Europäisches Patentamt

European Patent Office

Office européen des brevets

(11) Publication number: **0 051 402**
**B1**

(12) **EUROPEAN PATENT SPECIFICATION**

(45) Date of publication of patent specification: **25.04.84**

(21) Application number: **81304970.7**

(22) Date of filing: **22.10.81**

(51) Int. Cl.³: **H 01 L 21/308,**
**H 01 L 21/467, G 03 F 7/26**

(54) A photomask for, and a method of, producing semiconductor devices.

(30) Priority: **31.10.80 JP 156206/80**

(43) Date of publication of application:
**12.05.82 Bulletin 82/19**

(45) Publication of the grant of the patent:
**25.04.84 Bulletin 84/17**

(84) Designated Contracting States:
**DE FR GB NL**

(56) References cited:
**DE - A - 2 416 186**

(73) Proprietor: **FUJITSU LIMITED**
**1015, Kamikodanaka Nakahara-ku**
**Kawasaki-shi Kanagawa 211 (JP)**

(72) Inventor: **Araihara, Satoshi**
**1230-202 Ida Nakahara-ku**
**Kawasaki-shi Kanagawa 211 (JP)**

(74) Representative: **Rackham, Stephen Neil et al,**
**GILL JENNINGS & EVERY 53-64 Chancery Lane**
**London WC2A 1HN (GB)**

Courier Press, Leamington Spa, England.

A photomask for, and a method of, producing semiconductor devices

This invention relates to a photomask for producing semiconductor devices.

A series of photoprocesses is used for producing semiconductor devices. Firstly, a mastermask is produced by making reduced copies of reticle patterns by reducing each pattern to one tenth of their original size. Secondly a copymask is produced by the inverse projection of the pattern of the mastermask. Then, the pattern on the mask is transferred onto a photoresist layer which is applied to, for example, a uniform metal layer on the surface of a semiconductor substrate.

A mastermask and a copymask comprise a transparent substrate of, for example, glass or silica, on which a mask pattern is formed by a metallic film, for example, chromium, or a metal oxide film such as chromium oxide. A contact exposure technique is commonly used for transferring the pattern from a mask onto the photoresist layer. Thus, light is irradiated from the back surface of the mask through the mask and onto the photoresist layer to be patterned. The surface of the photoresist layer and the patterning of the mask make close contact with each other and the patterning casts shadows over the photoresist layer so that only parts of the photoresist layer are exposed to light. However, minute particles of dust unavoidably adhere to the surfaces of the transparent substrate of the mask and these can also cast shadows.

During the contact exposure, images of the minute particles of dust are transferred together with the mask pattern onto the plain surface to be patterned. Thus, the transferred images of the minute particles of dust result in the formation of pin holes in the metal conductor when a negative type photoresist is used, and undesired residues of metal are deposited between the required pattern elements when a positive type photoresist is used, leading to disconnection and short circuiting of the metal conductor patterns, respectively.

According to one aspect of the invention a photomask comprising a transparent substrate on one surface of which a mask pattern is formed by a photoshielding film is characterised in that the opposite surface of the substrate is roughened so that rays of light incident upon the roughened surface are randomly refracted by it.

According to another aspect of the invention, a method for producing a semiconductor device includes the step of forming an image in a layer of photoresist on a semiconductor substrate by contact printing using a photomask having a mask pattern formed by a photoshielding film on one surface and a roughened opposite surface so that rays of light incident upon the other surface are randomly refracted to prevent dust particles present on the surfaces of the photomask casting shadows and contributing to the image in the photoresist.

The photomask may be a mastermask or a copymask.

Preferably the roughness of the opposite surface of the transparent surface has a maximum extent normal to the substrate in a range of from 1 $\mu$m to 50 $\mu$m and the width of the substrate is substantially 2.5 mm.

If the maximum extent of the roughness of the surface is larger than 50 $\mu$m, it becomes difficult to obtain a sharp image of the transferred pattern.

An example of an apparatus in accordance with this invention will now be described with reference to the accompanying drawings, in which

Figure 1 is a section through a photomask and substrate; and

Figure 2 is a scrap section to an enlarged scale of part of the roughened surface of the photomask.

A photomask comprises a glass substrate 1 having a thickness of 2.5 mm. One surface of the substrate 1 is roughened by sandblasting and the maximum extent of unevenness ranges from 1 to 50 $\mu$m. On the other surface of the substrate 1 a line pattern of chromium 2 is formed 0.1 $\mu$m in thickness with lines 11.6 $\mu$m in width. Minute particles of dust 3 are present on both surfaces of the substrate 1. The dust typically has a size or maximum dimension a factor of 10 smaller than the width of the pattern lines.

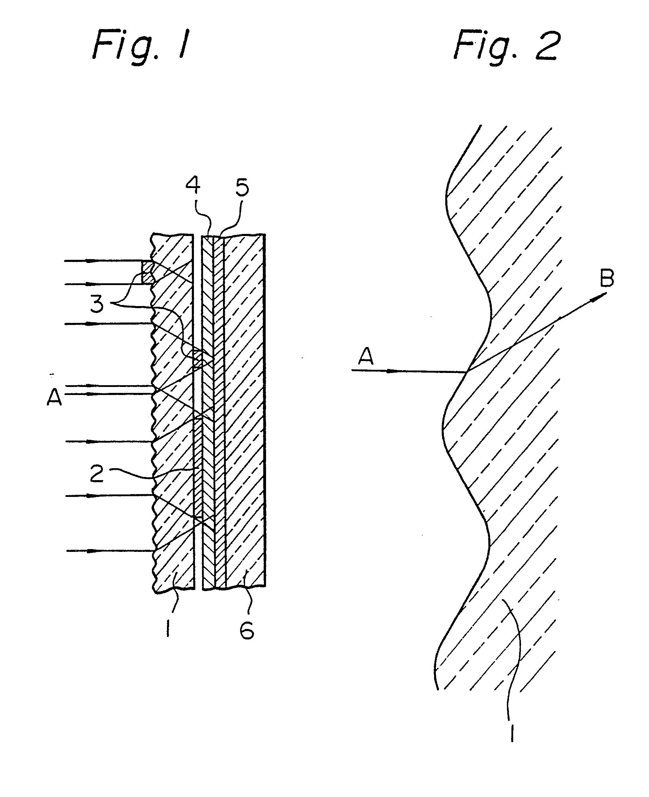

Rays of light incident on the even surface of the substrate 1 are refracted randomly, as shown in Figure 2. Since the rays of light are randomly refracted some of them are refracted beneath the images of the particles of dust and thus substantially no shadows are formed beneath the dust particles. A photoresist layer 4 is applied on top of an aluminium layer 5 which is in turn located on a silicon substrate 6. Whilst the dust particles 3 do not cast a shadow, the image of the patterning chromium 2 is clearly transferred on to the photoresist layer 4. The lines of the patterning chromium 2 are much wider than the size of the dust particles 3 and consequently, although the light is randomly refracted by the roughened surface a shadow is still cast by the patterning chromium 2. A slight change in the width of the lines of the patterning may occur.

In addition, the light energy required for the exposure of the photoresist layer 4 has to be increased by about 10% in comparison with a conventional photomask. The exposure time required is usually only increased by 1 or 2 seconds. Therefore, the present invention is no more trouble than the conventional method and apparatus used in the photoprocess technique for producing semiconductor devices and, yet is capable of transferring the exact mask pattern without the transfer of images of minute particles of dust. This improves the yield and the reliability of the semiconductor devices so produced.

The above example of the present invention describes the use of a copymask, however, the invention can also be applied to the production of a copymask from a mastermask.

## Claims

1. A photomask comprising a transparent substrate (1) on one surface of which a mask pattern is formed by a photoshielding film (2) characterised in that the opposite surface of the substrate (1) is roughened so that rays of light incident upon the roughened surface are randomly refracted by it.

2. A photomask according to claim 1, in which the photomask is a mastermask.

3. A photomask according to claim 1, in which the photomask is a copymask for producing an image by contact printing a photoresist (4) on the surface of a semiconductor substrate (6).

4. A photomask according to any one of the preceding claims, in which the roughness of the opposite surface of the transparent substrate (1) has a maximum extent in a direction normal to the substrate in a range from 1 $\mu$m to 50 $\mu$m.

5. A photomask according to claim 4, in which the thickness of the substrate (1) is substantially 2.5 mm.

6. A method for producing a semiconductor device including the step of forming an image in a layer of photoresist (4) on a semiconductor substrate by contact printing using a photomask having a mask pattern formed by a photoshielding film (2) on one surface and a roughened opposite surface so that rays of light incident upon the other surface are randomly refracted to prevent dust particles (3) present on the surfaces of the photomask casting shadows and contributing to the image in the photoresist (4).

## Revendications

1. Masque photographique comprenant un substrat transparent (1) sur une surface duquel une configuration de motifs de masquage est formée par une pellicule du type cache photographique (2), caractérisé en ce que la surface opposée du substrat (1) est rendue rugueuse si bien que des rayons lumineux arrivant sur la surface rendue rugueuse sont réfractés par celle-ci de manière aléatoire.

2. Masque photographique selon la revendication 1, dans lequel le masque photographique est un maître-masque.

3. Masque photographique selon la revendication 1, dans lequel le masque photographique est une copie de masque servant à produire une image par impression par contact d'un vernis photosensible (4) à la surface d'un substrat semiconducteur (6).

4. Masque photographique selon l'une quelconque des revendications précédentes, dans lequel la rugosité de la surface opposée du substrat transparent (1) possède une amplitude maximale, dans une direction perpendiculaire au substrat, appartenant à l'intervalle de 1 $\mu$m à 50 $\mu$m.

5. Masque photographique selon la revendication 4, dans lequel l'épaisseur du substrat (1) est sensiblement de 2,5 mm.

6. Procédé de production d'un dispositif à semiconducteurs comportant l'opération qui consiste à former une image dans une couche de vernis photosensible (4) disposée sur un substrat semiconducteur par un tirage par contact utilisant un masque photographique sur une surface duquel une configuration de motifs de masquage est formée par une pellicule de type cache photographique (2) et qui possède une surface opposée rendue rugueuse, si bien que des rayons lumineux arrivant sur l'autre surface se réfractent de manière aléatoire en empêchant que des particules de poussière (3) présentes sur les surfaces du masque photographique ne projettent des ombres et ne contribuent à l'image formée dans le vernis photosensible (4).

## Patentansprüche

1. Photomaske mit einem transparenten Substrat (1), auf dessen einer Oberfläche ein Maskenmuster durch einem lichtabschirmenden Film (2) gebildet ist, dadurch gekennzeichnet, daß die gegenüberliegende Oberfläche des Substrats (1) aufgerauht ist, so daß die auf die aufgerauhte Oberfläche einfallenden Lichtstrahlen von dieser willkürlich gebrochen werden.

2. Photomaske nach Anspruch 1, bei welcher die Photomaske eine Originalmaske ist.

3. Photomaske nach Anspruch 1, bei welcher die Photomaske eine Repromaske zur Erzeugung eines Bildes durch Kontaktkopieren eines Photoresistes (4) auf der Oberfläche eines Halbleitersubstrats (6) ist.

4. Photomaske nach einem der vorhergehenden Ansprüche, bei welcher die Rauhigkeit der gegenüberliegenden Oberfläche des transparenten Substrats (1) in einer Richtung senkrecht zu dem Substrat eine maximale Ausdehnung im Bereich von 1 $\mu$m bis 50 $\mu$m hat.

5. Photomaske nach Anspruch 4, bei welcher die Dicke des Substrats (1) im wesentlichen 2,5 mm beträgt.

6. Verfahren zur Herstellung einer Halbleitervorrichtung, mit einem Schritt zur Bildung eines Bildes in einer Schicht aus Photoresist (4) auf einem Halbleitersubstrat durch Kontaktkopieren unter Verwendung einer Photomaske, welche auf einer Oberfläche ein durch einen lichtabschirmenden Film (2) gebildetes Maskenmuster und eine aufgerauhte gegenüberliegende Oberfläche aufweist, so daß Lichtstrahlen, welche auf die andere Oberfläche einfallen willkürlich gebrochen werden, um zu verhindern, daß Staubpartikel (3), welche sich auf den Oberflächen der Photomaske befinden, Schatten werfen und zu dem Bild in dem Photoresist beitragen.

# Fig. 1

# Fig. 2